(19) Europäisches Patentamt
European Patent Office
Office européen des brevets

(11) Veröffentlichungsnummer: **0 045 852**
**B1**

(12) **EUROPÄISCHE PATENTSCHRIFT**

(45) Veröffentlichungstag der Patentschrift: **07.03.84**

(51) Int. Cl.³: **H 01 B 1/12,** H 01 L 29/28, H 01 L 31/02, C 08 K 5/50, C 08 L 65/02

(21) Anmeldenummer: **81105337.0**

(22) Anmeldetag: **09.07.81**

(54) **Verfahren zur Herstellung von elektrisch leitfähigen polymeren Systemen und deren Verwendung in der Elektrotechnik und zur antistatischen Ausrüstung von Kunststoffen.**

(30) Priorität: **01.08.80 DE 3029206**

(43) Veröffentlichungstag der Anmeldung: **17.02.82 Patentblatt 82/7**

(45) Bekanntmachung des Hinweises auf die Patenterteilung: **07.03.84 Patentblatt 84/10**

(84) Benannte Vertragsstaaten: **BE DE FR GB**

(56) Entgegenhaltungen:
**EP - A - 0 016 305**
**EP - A - 0 023 595**
**FR - E - 91 925**
**US - A - 4 204 216**

**ELEKTROTECHNISCHE ZEITSCHRIFT, Band 100, Nr. 7/8, April 1979, Seite 356 W. BAIER: "Halbleiter aus Kunststoff"**

(73) Patentinhaber: **BASF Aktiengesellschaft, Carl-Bosch-Strasse 38, D-6700 Ludwigshafen (DE)**

(72) Erfinder: **Naarmann, Herbert, Dr., Haardtblick 15, D-6719 Wattenheim (DE)**
Erfinder: **Muench, Volker, Dr., Luitpoldstrasse 114, D-6700 Ludwigshafen (DE)**
Erfinder: **Penzien, Klaus, Dr., Bensheimer Ring 18, D-6710 Frankenthal (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



ACTORUM AG

# Verfahren zur Herstellung von elektrisch leitfähigen polymeren Systemen und deren Verwendung in der Elektrotechnik und zur antistatischen Ausrüstung von Kunststoffen

Die Erfindung betrifft ein Verfahren zur Herstellung von elektrisch leitfähigen Polymeren mit elektrischen Leitfähigkeitswerten grösser als $10^{-2}$S/cm und deren Verwendung in der Elektroindustrie zur Herstellung von Sonnenzellen, zur Umwandlung und Fixierung von Strahlung und zur Herstellung elektrischer und magnetischer Schalter sowie zur antistatischen Ausrüstung von Kunststoffen.

Es ist bereits bekannt, organische Polymere aus der Reihe der polyphenylene durch oxidative Kupplung entsprechend der Literatur: «Macromolecular Syntheses Collective», 1, (1979), Seiten 109 bis 110 und «Naturwiss.» 56 (1969), Seiten 308 bis 313, herzustellen. Ausserdem ist die Herstellung von Polyphenylenen durch stufenweise Polykondensation nach R. Gehm und W. Kern aus «Makromolekulare Chemie» 7 (1951), Seiten 46 bis 61, bekannt, wobei besonders einheitliche para-verkettete methylsubstituierte Derivate erhalten werden, die nicht zusätzlich durch ortho- oder meta-verknüpfte Polymere verunreinigt sind. Die organischen Polymeren aus der Reihe der Heteropolyphenylene unterscheiden sich von den Polyphenylenen durch das Vorhandensein von Heteroatomen oder Heteroatome enthaltenden Gruppen zwischen den aromatischen Ringsystemen. Diese Polymeren sind z.B. beschrieben in «Macromolecular Synthesis», 6, (1978), Seiten 45 bis 48. Auch die Herstellung der organischen Polymere aus der Reihe der Polyacetylene durch Polymerisation von Acetylen ist bekannt. Sie ist z.B. in den Arbeiten von Hatano in «J. Chem. Soc. Japan, Ind. Chem. Sect.» 65, (1962), Seite 723 ff. sowie von D.J. Berets et al «Trans. Farad. Soc.» 64, (1968), Seite 823 ff. beschrieben. Auch in neueren Publikationen von H. Shirakawa et al, «J. Chem. Soc., Chem. Comn.» 1977, Seiten 578 bis 580 ist die Polymerisation von Acetylen zu Polyacetylen mit Hilfe von Ziegler-Katalysatoren beschrieben. Nach den genannten Methoden werden Produkte erhalten, die in den üblichen Lösungsmitteln vollkommen unlöslich sind und als schwarze amorphe bis teilkristalline Materialien anfallen. Auch die in den «Ber. Bunsenges. Phys. Che.» 68, (1964), Seiten 558 bis 567 erhaltenen Materialien werden mit umfasst.

Der Erfindung lag die Aufgabe zugrunde, die an sich bekannten organischen Polymeren aus der Reihe der Polyphenylene, Heteropolyphenylene oder Polyacetylene durch Zusätze in elektrisch leitfähige Polymere mit elektrischen Leitfähigkeitswerten grösser als $10^{-2}$S/cm umzuwandeln und darüber hinaus entscheidend gegen oxidative Schädigung zu stabilisieren und die Verarbeitbarkeit und Anwendungsbreite deutlich zu erhöhen.

Diese Aufgabe wird erfindungsgemäss dadurch gelöst, dass man den organischen Polymeren aus der Reihe der Polyphenylene, Heteropolyphenylene oder Polyacetylene unter Ausschluss von Wasserfeuchtigkeit und von Luft in Mengen von 0,1 bis 70, vorzugsweise 5 bis 25 Gewichtsprozent, bezogen auf das Polymere, ein Komplexierungsmittel des Typs:

$$A^{+}B[P(R)_3]_4,$$

worin

A = Li, Na, K, Rb, Cs, 1/2 Ba, 1/2 Ca 1/2 Sr, 1/2 Ra oder 1/3 La;

B = Co, Ir oder Rh und

R = ein aliphatischer $C_1$– bis $C_5$-Kohlenwasserstoff, zusetzt.

Nach bevorzugter Verfahrensweise wird das Komplexierungsmittel bei Temperaturen zwischen −80 und +30 °C in organischen Äthern zugesetzt.

Nach dem erfindungsgemässen Verfahren wird den organischen Polymeren unter Ausschluss von Wasserfeuchtigkeit, von Sauerstoff und von Stickstoff 0,1 bis 70, bevorzugt 5 bis 25 Gewichtsprozent, bezogen auf das Polymere, ein Komplexierungsmittel des Typs $A^{+}B[P(R)_3]_4$, worin A = Lithium, Natrium, Kalium Rubidium, Cäsium, 1/2 Barium, 1/2 Calcium, 1/2 Strontium, 1/2 Radium oder 1/3 Lauthan; B = Kobalt, Iridium oder Rhodium und R = ein aliphatischer $C_1$- bis $C_5$-Kohlenwasserstoff. Das Einarbeiten der Zusätze erfolgt vorzugsweise unter Argonatmosphäre. Bevorzugt wird die Komplexierungsreaktion bei Temperaturen zwischen −80 und +30 °C in organischen Äthern durchgeführt. Als Äther werden bevorzugt Tetrahydrofuran, Anisol, Dioxan oder die Dimeren dieser Äther verwendet. Die Äther werden nach dem Einarbeiten bei Temperaturen unter 30 °C im Vakuum abgezogen. Die verwendeten Komplexierungsmittel sind an sich bekannt und in der «Zeitschrift für Naturforschung» 326 (1977) Seiten 138 ff. beschrieben.

Durch die genannten Zusätze können elektrische Leitfähigkeitsanstiege von einigen Grössenordnungen erreicht werden. Die Ausgangsleitfähigkeit der organischen Polymeren betrugen $10^{-12}$S/cm. Die erfindungsgemässen organischen Polymeren haben Ausgangsleitfähigkeiten von weniger als $10^{-2}$S/cm, liefern aber nach der Zugabe der erfindungsgemässen Zusätze Leitfähigkeiten grösser als $10^{-2}$S/cm.

Die elektrischen Leitfähigkeitswerte werden in S/cm bei 30 °C gemessen, die Messung selbst erfolgt nach der Methode von F. Beck, «Berichte Bunsengesellschaft, Physikalische Chemie» 68 (1964), Seiten 558 bis 567. Die elektrische Leitfähigkeitswerte der erfindungsgemässen leitfähigen Polymeren ist grösser als $10^{-2}$S/cm.

Die erfindungsgemäss hergestellten elektrisch leitfähigen polymeren Systeme mit elektrischen Leitfähigkeiten grösser als $10^{-2}$S/cm sind zur antistatischen Ausrüstung von Kunststoffen, zur Herstellung von Sonnenzellen, zur Umwandlung und Fixierung von Strahlung sowie zur Herstellung elektrischer und magnetischer Schalter geeignet. Durch die Zusätze der Komplexierungsmittel entstehen sogenannte n-Leiter (vgl. «J. Chem. Education», 46, (1969), Nr. 2, Seite 82).

Die in den folgenden Beispielen genannten Teile sind Gewichtsteile bzw. Molprozente.

Beispiel 1 bis 7

10 Teile eines organischen Polymeren werden unter Argonatmosphäre und Ausschluss von Feuchtigkeit mit dem jeweiligen Komplexierungsmittel versetzt, die Messung der elektrischen Leitfähigkeit erfolgt nach F. Beck «Ber. Bunsenges. Phys. Chem.» 68, (1964), Seiten 558 bis 567.

Tabelle

| Beispiel Nr. | organ. Polymeres Teile | Komplexierungsmittel $A^+ Co[P(R)_3]_4$ | | | Art und Menge in Gew.-% | Leitfähigkeit vor dem Zusatz | S/cm 30 °C nach dem Zusatz |
|---|---|---|---|---|---|---|---|
| | 10 | A | Co | R | | | |
| 1 | Polyacetylen nach Shirakawa 1) | Na | Co | $CH_3$ | 5 | $10^{-10}$ | $1{,}5\cdot10^{+2}$ |
| 2 | dito | K | Co | $CH_3$ | 10 | $10^{-10}$ | $1{,}9\cdot10^{+2}$ |
| 3 | dito | Li | Co | $CH_3$ | 20 | $10^{-10}$ | $2{,}5\cdot10^{+2}$ |
| 4 | dito | 1/2 La | Co | $CH_3$ | 15 | $10^{-10}$ | $0{,}4.10^{+2}$ |
| 5 | dito | 1/2 Ba | Co | $CH_3$ | 15 | $10^{-10}$ | $0{,}2\cdot10^{+2}$ |
| 6 | dito | 1/3 La | Co | $CH_3$ | 15 | $10^{-10}$ | $0{,}1\cdot10^{+2}$ |
| 7 | Polyacetylen nach Luttinger 2) | Na | Co | $C_2H_5$ | 20 | $10^{-10}$ | $8{,}5\cdot10^{+1}$ |
| 8 | Polyacetylen nach Shirakawa 1) | Na | Rh | $C_3H_7$ | 20 | $10^{-10}$ | $7{,}3\cdot10^{+1}$ |
| 9 | dito | Na | Ir | $CH_3$ | 25 | $10^{-10}$ | $8{,}6\cdot10^{+1}$ |
| 10 | dito | K | Co | $CH_3$ | 30 | $10^{-10}$ | $1{,}9\cdot10^{+2}$ |
| 11 | dito | K | Co | $c_4H_9$ | 40 | $10^{-10}$ | $2{,}3\cdot10^{+1}$ |
| 12 | Polyphenylen (3) | Na | Co | $CH_3$ | 25 | $10^{-8}$ | $2{,}4.10^{+1}$ |
| 13 | Polyphenylensulfid | Na | Co | $CH_3$ | 25 | $10^{-9}$ | $3{,}5\cdot10^{+1}$ |

1) J. Chem. Soc., Chem. Commn. 1977, 578 ff.
2) J. Org. Chem. 29 (1964) 2936 ff.
3) Ber. Bunsenges. Phys. Chem. 83, (1970) 427 ff.

**Patentansprüche**

1. Verfahren zur Herstellung von elektrisch leitfähigen Polymeren mit elektrischen Leitfähigkeitswerten grösser als $10^{-2}$S/cm, dadurch gekennzeichnet, dass man organischen Polymeren aus der Reihe der Polyphenylene, Heteropolyphenylene oder Polyacetylene unter Ausschluss von Wasserfeuchtigkeit und von Luft in Mengen von 0,1 bis 70, vorzugsweise 5 bis 25 Gewichtsprozent, bezogen auf das Polymere, ein Komplexierungsmittel des Typs:

$$A^+B[P(R)_3]_4,$$

worin

A = Li, Na, K, Rb, Cs, 1/2 Ba, 1/2 Ca, 1/2 Sr, 1/2 Ra oder 1/3 La;
B = Co, Ir oder Rh und
R = ein aliphatischer $C_1$- bis $C_5$-Kohlenwasserstoff, zusetzt.

2. Verfahren nach Anspruch 1, dadurch gekennzeichnet, dass das Komplexierungsmittel bei Temperaturen zwischen −80 und +30 °C in organischen Äthern zugesetzt wird.

3. Verwendung der nach Anspruch 1 hergestellten elektrisch leitfähigen Polymeren in der Elektrotechnik zur Herstellung von Sonnenzellen, zur Umwandlung und Fixierung von Strahlung und zur Herstellung elektrischer und magnetischer Schalter.

4. Verwendung der nach Anspruch 1 hergestellten elektrisch leitfähigen Polymeren zur antistatischen Ausrüstung von Kunststoffen.

**Revendications**

1. Procédé pour la préparation de polymères électriquement conducteurs, ayant des valeurs de conductibilité électrique de plus de $10^{-2}$S/cm, caractérisé en ce qu'on ajoute, à des polymères organiques de la série des polyphénylènes, des hétéropolyphénylènes ou des polyacétylènes, à l'abri de l'humidité aqueuse et de l'air, dans des proportions de 0,1 à 70, de préférence 5 à 25% en poids par rapport au polymère, un agent de complexation du type

$$A^+B[P(R)_3]_4$$

avec

A = Li, Na, K, Rb, Cs, 1/2 Ba, 1/2 Ca, 1/2 Sr, 1/2 Ra ou 1/3 La;
B = Co, Ir ou Rh et
R = un hydrocarbure aliphatique en $C_1$ à$C_5$.

2. Procédé selon la revendication 1, caractérisé en ce quel'agent de complexation est ajouté à une température comprise entre −80 et +30 °C dans des éthers organiques.

3. Utilisation des polymères électriquement conducteurs, préparés suivant la revendication 1, dans l'électrotechnique pour la fabrication de piles solaires, pour la transformation et la fixation du rayonnement et pour la fabrication de commutateurs électriques et magnétiques.

4. Utilisation des polymères électriquement conducteurs, préparés suivant la revendication 1, pour le traitement antistatique de matières synthétiques.

**Claims**

1. A process for the production of electrically conductive polymers having an electrical conductivity of more than $10^{-2}$S/cm, wherein a complexing agent of the type

$$A^{+}B[P(R)_3]_4,$$

where

A is Li, Na, K, Rb, Cs, 1/2 Ba, 1/2 Ca, 1/2 Sr, 1/2 Ra or 1/3 La;
B is Co, Ir or Rh; and

R is an aliphatic hydrocarbon of 1 to 5 carbon atoms, is added to organic polymers selected from the polyphenylene, heteropolyphenylene or polyacetylene series, while excluding moisture and air, in an amount of from 0.1 to 70% by weight, preferably from 5 to 25% by weight, based on the polymer.

2. A process as claimed in claim 1, wherein the complexing agent is added in an organic ether at a temperature of from −80 to +30 °C.

3. The use of the conductive polymers produced as claimed in claim 1 in electrical engineering for the manufacture of solar cells, for the conversion and fixation of radiation, and for the manufacture of electrical and magnetic switches.

4. The use of the conductive polymers produced as claimed in claim 1 for the antistatic finishing of plastics materials.